# EUROPEAN PATENT SPECIFICATION

(11) **EP 4 712 737 B1**
(45) Date of publication and mention of the grant of the patent: **18.11.2026**
(21) Application number: 25186024.3
(22) Date of filing: 27.06.2025
(51) Int. Cl.: H10F 19/90, H10F 71/00, H10F 77/20

(54) **METHOD FOR PREPARING A PHOTOVOLTAIC MODULE**
VERFAHREN ZUR HERSTELLUNG VON FOTOVOLTAISCHEM MODUL
PROCÉDÉ DE PRÉPARATION D'UN MODULE PHOTOVOLTAÏQUE

(30) Priority: 11.09.2024 CN 202411270016
(43) Date of publication of application: 18.03.2026
(73) Proprietor: Tongwei Solar (Meishan) Co., Ltd., Meishan, Sichuan 620041 (CN)
(72) Inventor: HUANG, Zhi, Meishan, 620041 (CN); SHI, Xinxin, Meishan, 620041 (CN)
(74) Representative: Gill Jennings & Every LLP

(56) References cited:
- EP-B1- 4 053 921
- CN-A- 117 790 621
- GROSER STEPHAN ET AL: "Microscale Contact Formation by Laser Enhanced Contact Optimization", IEEE JOURNAL OF PHOTOVOLTAICS, IEEE, vol. 12, no. 1, 6 December 2021 (2021-12-06), pages 26 - 30, XP011895041, ISSN: 2156-3381, [retrieved on 20211221], DOI: 10.1109/JPHOTOV.2021.3129362
- FAN YUAN ET AL: "Investigation of the Ag-Si Contact Characteristics of Boron Emitters for n-Tunnel Oxide-Passivated Contact Solar Cells Metallized by Laser-Assisted Current Injection Treatment", SOLAR RRL, vol. 8, no. 13, 12 June 2024 (2024-06-12), XP093286605, ISSN: 2367-198X, DOI: 10.1002/solr.202400268
- KRASSOWSKI EVE ET AL: "Reliability Evaluation of Photovoltaic Modules Fabricated from Treated Solar Cells by Laser-Enhanced Contact Optimization Process", SOLAR RRL, vol. 6, no. 5, 5 November 2021 (2021-11-05), XP093344466, ISSN: 2367-198X, [retrieved on 20251205], DOI: 10.1002/solr.202100537

## Description

### TECHNICAL FIELD

The present invention relates to the field of solar cells. A photovoltaic module is described and a method for preparing the same is disclosed.

### BACKGROUND

During manufacturing solar cells, laser-induced contact treatment on solar cells can significantly improve the photoelectric conversion efficiency and other performances of solar cells. However, after the solar cells that have been subjected to a laser-induced contact treatment are further assembled into a photovoltaic module, indicators such as the photoelectric conversion efficiency will decrease significantly, making it difficult to maintain the already improved performance advantages of the solar cells.

GROSER STEPHAN ET AL: "Microscale Contact Formation by Laser Enhanced Contact Optimization", IEEE JOURNAL OF PHOTOVOLTAICS, IEEE, vol. 12, no. 1, 6 December 2021 (2021-12-06), pages 26-30, discloses a microstructure analysis of the contact formation at the silver grid finger and the silicon wafer interface and the study of local material properties of the interface before and after LECO treatment.

FAN YUAN ET AL: "Investigation of the Ag-Si Contact Characteristics of Boron Emitters for n-Tunnel Oxide-Passivated Contact Solar Cells Metallized by Laser-Assisted Current Injection Treatment", SOLAR RRL, vol. 8, no. 13, 12 June 2024 (2024-06-12), discloses a comparison of the interfacial Ag-Si contact characteristics on boron-doped p⁺ emitters and the electrical properties of industrial n-TOPCon solar cells that feature a LECO treatment and a specific Ag paste with those of n-TOPCon solar cells with a standard Ag/Al paste process.

### SUMMARY

In order to solve the above-mentioned technical problems, a method for preparing a photovoltaic module according to claim 1 is disclosed in the present invention, in which electrical properties such as photoelectric conversion efficiency of solar cells improved by the laser-induced contact treatment can be maintained after the solar cells are assembled into a photovoltaic module. A photovoltaic module is described.

In a first aspect, a method for preparing a photovoltaic module is provided according to an embodiment of the present invention, including:
printing a grid line paste on a half-finished solar cell, and sintering the grid line paste to form a grid line precursor, wherein the half-finished solar cell includes a substrate having a pyramidal textured structure on a surface thereof, and a semiconductor layer and a passivation layer that are sequentially provided on the substrate;
subjecting the grid line precursor to a laser-induced contact treatment to form a metal grid line, and enabling the metal grid line to extend through the passivation layer to be in a direct contact with the semiconductor layer to obtain a solar cell, wherein a plurality of enhanced conductive microstructures are formed at a contact interface between the metal grid line and the semiconductor layer, and the plurality of enhanced conductive microstructures are aggregated in a specified area of the pyramidal textured structure, and the specified area is an area centered on a tip of the pyramidal textured structure on the surface of the semiconductor layer and within a distance from the tip of less than or equal to 1 µm;
placing an electrical connector on the metal grid line, and pressing the electrical connector, such that the electrical connector and the metal grid line have a conductive contact area;
applying an adhesive to the conductive contact area to connect a plurality of solar cells into a cell string, wherein pressing the electrical connector and applying the adhesive are performed at a predetermined temperature less than or equal to 180°C, and the enhanced conductive microstructures are aggregated in the specified area in the solar cells of the cell string; and
stacking and laminating the cell string to obtain the photovoltaic module.

In one embodiment, the metal grid line includes a busbar and a finger that are arranged perpendicular to each other, and a pad located at at least one of the busbar, the finger, and an intersection of the busbar and the finger. A line width of the finger is in a range of 15 µm to 25 µm, and an area of the pad is in a range of 0.04 mm×0.04 mm to 1.1 mm×1.1 mm. During pressing the electrical connector, a pressure is applied to an intersection of the electrical connector and the pad, such that the electrical connector and the pad form the conductive contact area.

In one embodiment, the metal grid line is a busbar-free grid line, and pressing the electrical connector includes: placing the electrical connector on the metal grid line in a direction perpendicular to an extending direction of the metal grid line, such that the electrical connector and the metal grid line form an intersection, and applying a pressure to a position of the electrical connector corresponding to the intersection, such that the conductive contact area is formed in the position of the intersection.

In one embodiment, during pressing the electrical connector, a pressure is applied to the electrical connector for 10 s to 30 s; and/or a pressure applied to the electrical connector is in a range of 3 N to 5 N.

In one embodiment, during stacking and laminating the cell string, a temperature of lamination is in a range of 150°C to 200°C.

In one embodiment, the electrical connector is a tin-bismuth alloy solder ribbon with a soldering temperature of 150°C to 180°C.

In one embodiment, the predetermined temperature is room temperature; and/or
the adhesive is a conductive adhesive.

In one embodiment, the substrate is a silicon substrate; and/or
the semiconductor layer is a crystalline silicon semiconductor layer doped with a conductive element; and/or
the passivation layer includes one or more layers of an aluminum oxide layer, a silicon nitride layer, a silicon oxynitride layer, and a silicon oxide layer; and/or
the grid line paste is a silver paste, and an aluminum content in the grid line paste is less than or equal to 1wt%.

According to the first aspect, the enhanced conductive microstructure includes a metal dendrite conductor.

In one embodiment, subjecting the grid line precursor to the laser-induced contact treatment includes: applying a reverse bias voltage of 9 V to 15 V when laser conditions are satisfied, and the laser conditions include: a single wavelength spectrum with a wavelength of 500 nm to 1200 nm, a current density of 1000 A/cm² to 1400 A/cm², and a scanning rate of 35 m/s to 55 m/s.

In one embodiment, the solar cell includes a back-contact solar cell or a passivated contact solar cell.

In a second aspect not part of the invention, a photovoltaic module is described, which is prepared by the method described in the first aspect.

In one embodiment, the photovoltaic module includes:
a cell string;
an adhesive film layer encapsulated on an outside of the cell string; and
a light-transmitting cover plate and a back plate that are arranged on opposite surfaces of the adhesive film layer away from the cell string, respectively.

The electrical connector of the solar cells obtained after laser-induced contact treatment is pressed and an adhesive is applied at low temperature, and the resulting cell string is then laminated to prepare a photovoltaic module, which reduces the impact of the cell string manufacturing process on performances of the solar cells, ensuring that the enhanced conductive microstructures formed by the laser-induced contact treatment can still have excellent conductive properties in the cell string, thereby enabling the improvement effect of the cell performances to be maintained from the solar cells to the photovoltaic module, avoiding the problem that the already improved cell performances are significantly reduced in the photovoltaic module.

### BRIEF DESCRIPTION OF THE DRAWINGS

To illustrate the technical solutions according to the embodiments of the present invention more clearly, the accompanying drawings for describing the embodiments are introduced briefly below. Apparently, the accompanying drawings in the following description are only some embodiments of the present invention, and persons of ordinary skill in the art can derive other drawings from the accompanying drawings without creative efforts.
FIG. 1 is a schematic view of a half-finished solar cell according to an embodiment of the present invention (only the light-receiving side is shown).
FIG. 2 is a schematic view of a solar cell according to an embodiment of the present invention (only the light-receiving side is shown).
FIG. 3 is a schematic view of a specified area according to an embodiment of the present invention.
FIG. 4 is a schematic view of a connection between the solar cell and the electrical connector according to an embodiment of the present invention.

Reference Numerals:
1, half-finished solar cell; 2, solar cell; 3, electrical connector; 100, substrate; 101, pyramidal textured structure; 101a, specified area; 200, semiconductor layer; 300, passivation layer; 400, metal grid line; 401, busbar; 402, finger; 403, pad; 500, enhanced conductive microstructure.

### DETAILED DESCRIPTION OF THE EMBODIMENTS

The technical solutions in the embodiments of the present invention will be clearly and completely described hereinafter in combination with the accompanying drawings in the embodiments of the present invention. Obviously, the described embodiments are only a part of the embodiments of the present invention, but not all of the embodiments. All other embodiments obtained by a person skilled in the art based on the embodiments in the present invention without creative efforts are within the scope of the present invention.

In the present invention, the orientation or position relationship indicated by terms such as "on", "below", "left", "right", "front", "back", "top", "bottom", "inside", "outside", "vertical", "horizontal", "lateral", and "longitudinal" are based on the orientation or position relationship shown in the accompanying drawings. These terms are mainly used to better describe the present invention and embodiments, and are not used to limit the indicated devices, elements, or components to have a specific orientation, or to be constructed and operated in a specific orientation.

In addition, some of the aforementioned terms may be used not only to indicate orientation or position relationship, but also to express other meanings. For example, the term "on" may also be used to indicate an attach or connection relationship in certain circumstances. For a person skilled in the art, the specific meaning of these terms in the present invention can be understood according to specific situations.

In addition, the terms "install", "dispose", "provided with", "connect", and "join" should be understood broadly. For example, it may be a fixed connection, a detachable connection, or integrated; it may be a mechanical connection, or an electrical connection; it may be a direct connection, or an indirect connection through an intermediate medium, or it may be an internal connection between two devices, elements or components. For a person skilled in the art, the specific meaning of the aforementioned terms in the present invention can be understood according to specific situations.

In addition, the terms "first", "second", etc. are mainly used to distinguish different devices, elements, or components (the specific types and structures may be the same or different), and are not used to indicate or imply the relative importance and quantity of the indicated devices, elements, or components. Unless otherwise specified, "plurality" means two or more.

In a first aspect, a method for preparing a photovoltaic module is provided according to an embodiment of the present invention, including the following steps.

In a step of printing and pre-sintering, a grid line paste is printed on a half-finished solar cell and the grid line paste is sintered to form a grid line precursor.

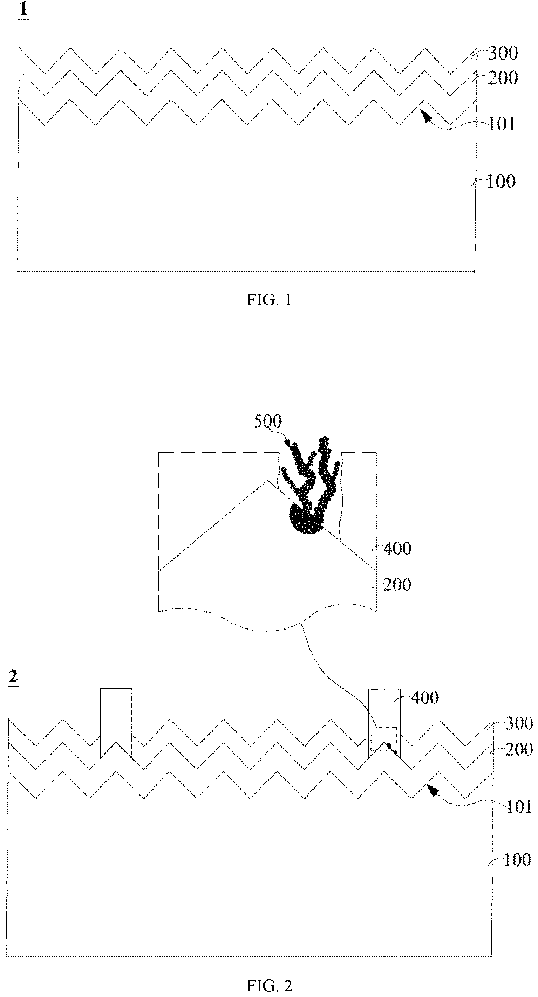

As shown in FIG. 1, the half-finished solar cell 1 includes a substrate 100 having a pyramidal textured structure 101 on a surface thereof, and a semiconductor layer 200 and a passivation layer 300 that are sequentially provided on the substrate 100.

In a step of preparing a solar cell, the grid line precursor is subject to a laser-induced contact treatment to form a metal grid line, and the metal grid line is enabled to extend through the passivation layer 300 to be in a direct contact with the semiconductor layer 200 to obtain the solar cell.

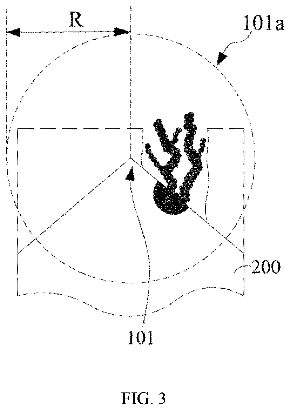

As shown in FIGS. 2 and 3, a plurality of enhanced conductive microstructures 500 are formed at a contact interface between the metal grid line 400 and the semiconductor layer 200, and the plurality of enhanced conductive microstructures 500 are aggregated in a specified area 101a of the pyramidal textured structure 101. The specified area 101a is an area centered on a tip of the pyramidal textured structure 101 on the surface of the semiconductor layer 200 and within a distance from the tip of less than or equal to 1 µm.

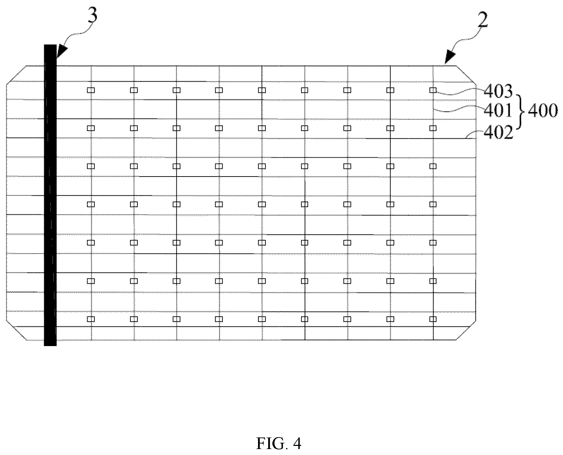

In a step of connecting an electrical connector, as shown in FIG. 4, the electrical connector 3 is placed on the metal grid line 400, and the electrical connector 3 is pressed, such that the electrical connector 3 and the metal grid line 400 have a conductive contact area.

In a step of adhesive fixation, an adhesive is applied to the conductive contact area to connect a plurality of solar cells 2 into a cell string. The step of pressing the electrical connector and applying the adhesive are performed at a predetermined temperature less than or equal to 180°C, and the enhanced conductive microstructures 500 are aggregated in the specified area 101a in the solar cells 2 of the cell string.

In a step of stacking and laminating, the cell string is stacked and laminated to obtain the photovoltaic module.

In the aforementioned photovoltaic module and the method for preparing the same, the electrical connector 3 of the solar cells 2 obtained after laser-induced contact treatment is pressed and an adhesive is applied at low temperature, and then the photovoltaic module is obtained by lamination, which ensures that the enhanced conductive microstructures 500 formed by the laser-induced contact treatment can still have excellent conductive properties in the solar cell 2, thereby enabling the improvement effect of the cell performances to be maintained from the solar cells to the photovoltaic module, avoiding the problem that the already improved cell performances are significantly reduced in the photovoltaic module.

Firstly, during preparing the solar cell 2, the laser-induced contact treatment is first performed to form enhanced conductive microstructures 500 at the contact interface between the semiconductor layer 200 and the metal grid line 400 of the solar cell 2. The enhanced conductive microstructures 500 are mainly aggregated at the tip of the pyramidal textured structure 101 and the surrounding area, which has the advantages of reducing the contact resistance between the semiconductor layer 200 and the metal grid line 400, and improving the contact performances.

Secondly, it has been found that, taking the preparation of TOP-Con solar cells as an example, after the laser-induced contact treatment is performed on the light-receiving side of the solar cell 2, the minority carrier recombination loss is greatly reduced, the open-circuit voltage increases by 8 mV to 10 mV, and the photoelectric conversion efficiency of the solar cell 2 increases by 0.2% to 0.5%. However, after the solar cell 2 with improved performances is prepared into a photovoltaic module, the photoelectric conversion efficiency of the photovoltaic module decreases significantly, which fails to demonstrate the performance advantages of the technical improvement on the solar cell 2. The inventor has found through research that the main reason for the aforementioned technical problem is that during soldering the solar cells 2 into the cell string, their fill factor is greatly reduced, which in turn results in a loss of photoelectric conversion efficiency from the solar cell to the photovoltaic module.

Further research reveals that, the solar cell 2 after laser-induced contact treatment will generate the enhanced conductive microstructures 500 at the contact interface between the semiconductor layer 200 and the metal grid line 400, and the enhanced conductive microstructures 500 are aggregated in an area surrounding the tip of the pyramidal textured structure 101. This structure and the distribution position are beneficial to improving the carrier transport capacity, and thus beneficial to reducing the contact resistance between the semiconductor layer 200 and the metal grid line 400. However, excessively high soldering temperature (usually over 200°C) during soldering the solar cells 2 into a cell string may damage the aforementioned enhanced conductive microstructures 500, causing a plurality of enhanced conductive microstructures 500 originally concentrated in the area surrounding the tip of the pyramidal textured structure to disperse, thereby resulting in poor contact between the semiconductor layer 200 and the metal grid line 400, and affecting the fill factor of the solar cell 2.

To solve the aforementioned problems, according to an embodiment of the present invention, provided that a laser-induced contact treatment is performed to improve the performances of the solar cell 2, the electrical connector 3 is first placed on the metal grid line 400 and pressed at a predetermined temperature less than or equal to 180°C, and then an adhesive is applied, such that the electrical connector 3 and the metal grid line 400 can be in direct contact with each other through pressure to form a conductive contact area, and an adhesive is applied to the conductive contact area. Since pressing and applying the adhesive are performed at a relatively low temperature, the enhanced conductive structures in the solar cell 2 are not damaged and are still aggregated in the area surrounding the tip of the pyramidal textured structure 101 after the adhesive is applied. Therefore, in this process, the fill factor, the photoelectric conversion efficiency, and other performances of the solar cell 2 that have been improved do not show a significant performance decline due to the formation of the cell string.

Finally, on the basis that the performances of the solar cell 2 are maintained after the cell string is prepared, according to an embodiment of the present invention, the cell string is stacked and laminated. By lamination, the electrical connection between the electrical connector 3 and the metal grid line 400 can be further enhanced, thereby ensuring good structural connection and electrical connection stabilities between the electrical connector 3 and the metal grid line 400.

The specified area 101a refers to an area where the enhanced conductive microstructures 500 are aggregated surrounding the tip of the pyramidal textured structure 101 on the surface of the semiconductor layer 200. As shown in FIG. 3, the enhanced conductive microstructures 500 are mainly aggregated surrounding the tip of the pyramidal textured structure 101, and the scope of the surrounding area is within a radius R of 1 µm centered on the tip of the pyramid on the surface of the semiconductor layer 200.

The predetermined temperature is less than or equal to 180°C, including any value therebelow. For example, the predetermined temperature may be 180°C, 150°C, 120°C, 100°C, 80°C, 50°C, 45°C, 40°C, 35°C, 30°C, 25°C, 20°C, or 15°C. It should be noted that the predetermined temperature when the electrical connector is pressed and when the adhesive is applied can be the same or different. For example, the electrical connector is pressed at 50°C, and the adhesive is applied at 160°C. For another example, the electrical connector is pressed and the adhesive is both applied at 160°C.

In one embodiment, the predetermined temperature is room temperature. As used herein, the room temperature refers to an ambient temperature of 15°C to 25°C. By pressing the electrical connector and applying the adhesive at room temperature instead of soldering, damage to the enhanced conductive microstructures caused by soldering can be avoided, which is beneficial to maintaining the aggregation distribution advantage of the enhanced conductive microstructures 500 in the area surrounding the tip of the pyramidal textured structure 101 in the photovoltaic module, ensuring that the improvement of performances such as fill factor and photoelectric conversion efficiency will not be significantly reduced due to the preparation of cell string.

In one embodiment, the adhesive is a conductive adhesive. When the conductive adhesive may include, for example, a conductive polymer adhesive (such as adhesive made of polypyrrole or polyaniline), and a conductive glass adhesive and the like.

The specific steps of the above preparation method are explained below respectively.

In the step of pressing of the electrical connector, different pressing methods may be used according to different types of metal grid line 400.

In one embodiment, referring to FIG. 4, which is a schematic view of a connection between the solar cell 2 and the electrical connector 3 from a top view of the light-receiving side of the solar cell 2, and the convenience of illustration, the electrical connector 3 on some metal grid lines 400 is not shown. The metal grid line 400 includes a busbar 401 and a finger 402 that are arranged perpendicular to each other, and a pad 403 located at the busbar 401. A line width of the finger 402 is in a range of 15 µm to 25 µm, and an area of the pad 403 is in a range of 0.04 mm×0.04 mm to 1.1 mm×1.1 mm. It can be understood that the pad 403 can be located at at least one of the busbar 401, the finger 402, and an intersection of the busbar 401 and the finger 402. For example, the pad 403 may be located at the finger 402. The pad 403 may be located at the intersection of the busbar 401 and the finger 402. The present invention is not limited hereto.

For this type of metal grid line 400, during the step of pressing the electrical connector, a pressure is applied to the intersection of the electrical connector 3 and the pad 403, such that the electrical connector 3 and the pad 403 form a conductive contact area.

Since the area of the pad 403 is relatively large and it has a larger contact area than the finger 402, when pressure is applied to the intersection of the electrical connector 3 and the pad 403 to form the conductive contact area, on the one hand, due to the relatively large area of the pad 403, the requirement of alignment accuracy is relatively low, which helps to simplify the production process and reduce poor contact caused by alignment problems; on the other hand, the relatively large area of the pad 403 means that a larger metal area is in contact with the electrical connector 3, which is not only conducive to providing good electrical connection performance, but also conducive to the coordinated operation with subsequent lamination, thereby enhancing the mechanical bonding strength between the metal grid line 400 and the electrical connector 3, and helping to improve the durability of the photovoltaic module.

In another embodiment, the metal grid line is a busbar-free grid line. That is, the metal grid lines are all thin grids with relatively thin line width. For this type of metal grid line, the step of pressing the electrical connector includes: the electrical connector is placed on the metal grid line in a direction perpendicular to an extending direction of the metal grid line, such that the electrical connector and the metal grid line form an intersection, and a pressure is applied to a position of the electrical connector corresponding to the intersection, such that the conductive contact area is formed in the position of the intersection.

Further, during the step of pressing the electrical connector, a pressure is applied to the electrical connector 3 for 10 s to 30 s, and the pressure applied is in a range of 3 N to 5 N. The applied pressure and the period are controlled within this range, which not only can promote the direct contact between the electrical connector 3 and the metal grid line 400 and ensure the pressing effect, but also can avoid damage to the metal grid line 400 and the enhanced conductive microstructures 500.

During the step of stacking and laminating, a temperature of lamination is in a range of 150°C to 200°C. In addition, the electrical connector 3 is made of a lead-free tin-bismuth alloy solder ribbon with a soldering temperature of 150°C to 180°C. According to an embodiment of the present invention, a relatively low temperature of lamination is employed, and a lead-free tin-bismuth alloy solder ribbon with a relatively low melting point is employed for the electrical connector 3, such that during stacking and laminating, the alloy in the electrical connector 3 can melt and be in better connection with the metal grid line 400, thereby cooperating with the adhesive layer to enhance the structural connection and electrical connection reliabilities between the electrical connector 3 and the metal grid line 400.

During the step of stacking and laminating, the cell string, the adhesive film layer, the light-transmitting cover plate, and the back plate are firstly placed in a certain order, and then these layers are laminated to form the photovoltaic module. For example, the layers can be placed and stacked in the following order: the light-transmitting cover plate, the adhesive film layer, the cell string, the adhesive film layer, and the back plate. Then a laminator is used to heat the film layers to melt the adhesive film layers and bond the layers, and the layers are tightly combined by the pressure of the laminator. There may be other options for the stacking order and material layers, such as adding a transparent conductive film, a reflective film, etc., which are not limited in the present invention. The adhesive film layer can be a film layer made of a material with a melting point lower than 200°C, such as EVA film, POE film, PVB film, etc., which is not limited hereto.

In addition, when the electrical connector 3 is made of a lead-free tin-bismuth alloy solder ribbon with a soldering temperature of 150°C to 180°C, the solder ribbon includes an internal substrate (such as a copper core wire) and a solder layer coated on a surface of the substrate, and the solder layer is made of a lead-free tin-bismuth alloy solder with a soldering temperature of 150°C to 180°C. In an optional composition, in the lead-free tin-bismuth alloy solder, a mass percentage of tin is 42%, a mass percentage of bismuth is 57.6%, and the rest are auxiliary materials. For example, the auxiliary materials are metal elements such as silver, copper, and antimony, which is not limited hereto. For example, a low-temperature lead-free tin-bismuth alloy solder composed of 0.4 wt% Ag, 42 wt% Sn, and 57.6 wt% Bi is used, with a melting point of about 138°C.

As mentioned above, for the solar cell 2 after the laser-induced contact treatment, during the solar cell 2 is soldered to form a cell string, the enhanced conductive microstructures 500 are damaged and become dispersed from aggregated in the specified area 101a, resulting in a decline of cell performances, thus the expected efficiency improvement effect cannot be achieved. This problem is further amplified during the lamination, that is, after the enhanced conductive microstructures 500 are damaged and become dispersed, it is prone to be damaged to a more severe extent during the lamination. In contrast, for conventional solar cells 2 that have not subjected to a laser-induced contact treatment, there is no issue of significantly reduced contact performances between the semiconductor layer 200 and the metal grid line 400 after soldering into a cell string, and no issue of more significant performance degradation after lamination.

In the present invention, since the cell string is prepared by pressing and applying an adhesive at low temperature, the enhanced conductive microstructures 500 are not severely damage and are still mainly aggregated in the area surrounding the tip of the pyramidal textured structure 101. Therefore, when the cell string with such structural characteristics is laminated, the lower temperature of lamination only promotes the further fusion of the electrical connector 3 and the metal grid line 400, and does not cause damage to the enhanced conductive microstructures 500, ultimately achieving the advantage of improved cell performances from the cell to the photovoltaic module, rather than a significant decline.

In an embodiment of the present invention, the half-finished solar cell 1 includes a substrate 100 having a pyramidal textured structure 101 on a surface thereof, and a semiconductor layer 200 and a passivation layer 300 that are sequentially provided on the substrate 100. The solar cell 2 further includes a metal grid line 400 extending through the passivation layer 300 and in direct contact with the semiconductor layer 200.

The substrate 100 is a silicon substrate 100. The silicon substrate 100 may be subjected to a texturing treatment to form a pyramidal textured structure 101 on a surface thereof.

The semiconductor layer 200 is a crystalline silicon semiconductor layer doped with a conductive element. The conductive element may be an N-type conductive element (such as phosphorus) or a P-type conductive element (such as boron). The semiconductor layer 200 may be a diffused silicon layer formed by thermally diffusing a conductive element into the substrate 100, or may be a crystalline silicon layer doped with a doping element formed on the substrate 100 by a deposition method (e.g., an LPCVD deposition method or a PECVD deposition method). Since the semiconductor layer 200 is formed on the substrate 100 in the aforementioned way, the semiconductor layer 200 also has a pyramidal textured structure 101 conforming to the substrate 100. The semiconductor layer 200 is arranged on the light-receiving side of the substrate 100.

The passivation layer 300 is arranged on a side of the semiconductor layer 200 away from the substrate 100. The passivation layer 300 includes one or more layers of an aluminum oxide layer, a silicon nitride layer, a silicon oxynitride layer, and a silicon oxide layer. For example, the passivation layer 300 includes a first passivation layer 300 arranged adjacent to the semiconductor layer 200 and a second passivation layer 300 arranged away from the semiconductor layer 200. The first passivation layer 300 is an aluminum oxide layer, which mainly plays a passivation role. The second passivation layer 300 is a composite film layer of a silicon nitride layer, a silicon oxynitride layer, and a silicon oxide layer, which plays a passivation role as well as an anti-reflection role. For another example, the second passivation layer 300 may be a single film layer, which is not limited in the present invention.

In addition, the grid line paste used to prepare the metal grid line 400 is a silver paste, and an aluminum content in the grid line paste is less than or equal to 1 wt%.

In addition, the enhanced conductive microstructure 500 includes a metal dendrite conductor. The enhanced conductive microstructure 500 is a conductive structure formed at the contact interface between the metal grid line 400 and the semiconductor layer 200 after the laser-induced contact treatment. For example, when the semiconductor layer 200 is a crystalline silicon semiconductor layer 200 doped with a conductive element, the grid line paste is a silver paste, and the metal grid line 400 is a silver grid line, the enhanced conductive microstructure 500 includes a silver dendrite conductor grown at the contact interface, and the silver dendrite conductor is a crystal formed by melting and recrystallizing the metal silver particles in the silver paste. In the related art, the carrier transport between the semiconductor layer 200 and the metal grid line 400 generally only depends on the metal silver particles, while in one embodiment, the silver dendrite conductor has a stronger carrier transport ability than the metal silver particles, which can enhance the contact performances between the metal grid line 400 and the semiconductor layer 200, and reduce the contact resistance.

Further, the metal dendrite conductor includes a crystalline main chain and a crystalline side chain extending from the crystalline main chain in a direction different from a growth direction of the crystalline main chain, such that the metal dendrite conductor as a whole has a divergent shape of a dendrite, so as to increase the contact area between the semiconductor layer 200 and the metal grid line 400.

The preparation of the solar cell 2 is described below.

A reverse bias voltage is applied during the laser-induced contact treatment of the grid line precursor. On the one hand, the reverse bias voltage is used to further enhance the built-in electric field of the solar cell 2 at the contact interface between the semiconductor layer 200 and the grid line precursor. On the other hand, a large number of photo-generated carriers (i.e., electron-hole pairs) are generated through the laser-induced contact treatment. Through the combined effect of these two aspects, electron carriers and hole carriers are sorted by the electric field, and carriers of one charge type are quickly transported to the semiconductor layer 200 under the acceleration of the electric field. When the surface of the semiconductor layer 200 has the pyramidal textured structure 101, carriers are more easily transported to the tip of the pyramidal textured structure 101 and a position surrounding the tip.

The tip of the pyramidal textured structure 101 and the position surrounding the tip become the specified area 101a where the enhanced conductive microstructures 500 are subsequently aggregated. Specifically, after the laser-induced contact treatment is withdrawn, the temperature of the contact area between the metal grid line 400 and the semiconductor layer 200 decreases, and metal atoms continuously precipitate from the common crystalline composed of the metal element and the semiconductor element to form a conductive eutectic (for example, when the metal grid line 400 is a silver grid line and the semiconductor layer 200 is a crystalline silicon semiconductor layer 200 doped with a conductive element, the conductive eutectic is a eutectic formed by the silver element and the silicon element), and the enhanced conductive microstructure 500 (for example, a silver dendrite conductor) is crystallized and grown with the conductive eutectic as the nucleation point.

In one embodiment, the conditions of the laser-induced contact treatment includes: a reverse bias voltage of 9 V to 15 V is applied when laser conditions are satisfied, and the laser conditions include: a single wavelength spectrum with a wavelength of 500 nm to 1200 nm, a current density of 1000 A/cm² to 1400 A/cm², and a scanning rate of 35 m/s to 55 m/s.

Optionally, the solar cell in an embodiment may be a back-contact solar cell or a passivated contact solar cell.

In a second aspect not part of the invention, a photovoltaic module is described, which is prepared by the method described in the first aspect.

Further, the photovoltaic module includes: a cell string; an adhesive film layer encapsulated on an outside of the cell string; and a light-transmitting cover plate and a back plate that are arranged on opposite surfaces of the adhesive film layer away from the cell string, respectively. The cell string includes a plurality of solar cells, and each solar cell includes: a substrate having a pyramidal textured structure on a surface thereof, and a semiconductor layer and a passivation layer that are sequentially provided on the substrate; a metal grid line extending through the passivation layer to be in a direct contact with the semiconductor layer; a plurality of enhanced conductive microstructures formed at a contact interface between the metal grid line and the semiconductor layer, wherein the plurality of enhanced conductive microstructures are aggregated in a specified area of the pyramidal textured structure, and the specified area is an area centered on a tip of the pyramidal textured structure on the surface of the semiconductor layer and within a distance from the tip of less than or equal to 1 µm; and an electrical connector connected to the metal grid line.

The photovoltaic module will be further described below in combination with more specific examples. In addition, the grid line paste, the solder ribbon and the like used in the following examples can all be commercially available. For example, the grid line paste used a commercially available silver grid line paste of DK-93T model, and the Al content in the grid line paste was 0.05 wt% to 0.10 wt%, and the oxygen content was 1.0 wt% to 5.0 wt%. The contents of element in the silver grid line paste can be tested by an energy dispersive spectrometer (EDS).

### Example 1

A 72-cell photovoltaic module was provided in this example, and the preparation method thereof was as follows.

A grid line paste was printed on a half-finished solar cell and the grid line paste was sintered to form a grid line precursor. The half-finished solar cell included a silicon substrate having a pyramidal textured structure on a surface thereof, and a boron-doped crystalline silicon layer, an aluminum oxide passivation layer, and a silicon oxynitride passivation anti-reflection layer that are sequentially arranged on a light-receiving side of the silicon substrate as an anti-reflection layer. A temperature of sintering was 730°C to 750°C.

The grid line precursor was subjected to a laser-induced contact treatment to form a metal grid line, and the metal grid line was enabled to extend through the silicon oxynitride passivation anti-reflection layer and the aluminum oxide passivation layer to be in direct contact with the boron-doped crystalline silicon layer, and enhanced conductive microstructures aggregated in a specified area of the pyramidal textured structure was formed at the contact interface. The specified area was an area centered on a tip of the pyramidal textured structure on the surface of the boron-doped crystalline silicon layer and within a distance from the tip of less than or equal to 1 µm. The metal grid line was a silver grid line, including a busbar and a finger that were perpendicular to each other, and a pad provided on the busbar. A line width of the finger was 20 µm, and an area of the pad was 0.96 mm². A reverse bias voltage was 15 V, and laser conditions included: a laser wavelength of 1064 nm, a current density of 1200 A/cm², and a scanning rate of 40 m/s.

The electrical connector was placed on the metal grid line, and a pressure of 4 N was applied to an intersection of the electrical connector and the pad for 20 seconds, such that the electrical connector and the pad of the metal grid line had a conductive contact area. The electrical connector was a lead-free tin-bismuth alloy solder ribbon with a soldering temperature of 150°C to 180°C.

A conductive adhesive was applied to the conductive contact area to connect a plurality of solar cells into a cell string. The electrical connector was pressed and the adhesive was applied both at a predetermined temperature of 180°C.

The cell string was stacked and laminated to obtain the photovoltaic module. A temperature of lamination was 150°C to 200°C.

### Examples 2 to 3

Compared with Example 1, the difference between Example 2 to 3 lied in the predetermined temperature, see Table 1.

### Comparative Examples 1 to 3

Compared with Example 1, the difference between Comparative Examples 1 to 3 mainly lied in the predetermined temperature, see Table 1. In addition, in Comparative Examples 1 to 3, the electrical connector was not pressed and the adhesive was not applied. Instead, the electrical connector and the metal grid line were directly subjected to a high-temperature soldering at the predetermined temperature. The solder ribbon used was a tin-coated copper ribbon, and the coating composition included 63 wt% of Sn and 37 wt% of Pb.

### Performance test

Contact resistance test is carried out using the TLM method (Transmission Line Method).

Fill factor, photoelectric conversion test: IV test was to obtain a complete IV curve by precisely controlling the voltage applied to the solar cell and measuring the corresponding current value. During the test, the voltage of the tester gradually changed, starting from the open-circuit voltage (i.e. the voltage when the solar cell was not connected to a load) and gradually decreasing to the voltage corresponding to the short-circuit current (i.e. the current when the solar cell was short-circuited). At each voltage point, the tester will record the corresponding current value and finally draw a complete IV curve. FF= ImVm / IscVoc, the rectangular area formed by the maximum power point on the IV curve divided by the area formed by Voc and Isc was the FF, that is, the fill factor. The photoelectric conversion test was carried out at irradiation intensity of 1000M/cm² and operating temperature of the solar cell of 25°C±2°C, the maximum output power was divided by the sunlight intensity, multiplied by the light absorption area of the solar cell, and multiplied by 100%.

Power test of photovoltaic module: the photovoltaic module was exposed to an environment with a known light source, and the output power of the module was calculated by measuring the current and voltage. Specifically, a standard light source with known light intensity was first selected and illuminated onto the surface of the module, then the output current of the module was measured, the reading was recorded at the output end by connecting to a voltmeter, and the output voltage value was obtained. The power can be obtained based on the product of current and voltage.

**Table 1 Performance test results of Examples 1 to 3 and Comparative Examples 1 to 3**

| | Predetermined temperature (°C) | Contact resistance (mOhm·cm²) | Difference in fill factor (%) | Difference in photoelectric conversion efficiency (%) | Power of photovoltaic module (W) |
|---|---|---|---|---|---|
| Example 1 | 180 | 2.45 | -0.25 | -0.067 | 582.6 |
| Example 2 | 150 | 2.40 | -0.11 | -0.032 | 583.4 |
| Example 3 | room temperature | 2.17 | 0 | 0 | 584.2 |
| Comparative Example 1 | 220 | 2.61 | -0.40 | -0.132 | 581.0 |
| Comparative Example2 | 240 | 3.85 | -0.75 | -0.247 | 578.3 |
| Comparative Example3 | 260 | 7.21 | -1.03 | -0.505 | 572.0 |

In Comparative Examples 1 to 3, solar cells that have been subjected to a laser-induced contact treatment were directly assembled into the cell string by high-temperature soldering at a relatively high predetermined temperature. As shown from the test results in Table 1, by comparing the performance indicators of the solar cells before and after assembly, it can be found that after high-temperature soldering, the fill factor of the solar cells decreased significantly and the photoelectric conversion efficiency lost a lot, indicating that the enhanced conductive microstructure formed by the laser-induced contact treatment was affected in the high-temperature soldering, such that the already improved cell performances cannot be maintained in the photovoltaic module. In contrast, in Examples 1 to 3 of the present invention, after the solar cells were assembled into the cell string, the losses of fill factor and photoelectric conversion efficiency were reduced. In particular, the fill factor and photoelectric conversion efficiency of the solar cell in Example 3 did not decrease before and after assembly, which is conducive to maintaining the performance improvement advantages brought by the laser-induced contact treatment to the solar cell.

## Claims

1. A method for preparing a photovoltaic module, comprising:
printing a grid line paste on a half-finished solar cell (1), and sintering the grid line paste to form a grid line precursor, wherein the half-finished solar cell (1) comprises a substrate (100) having a pyramidal textured structure (101) on a surface thereof, and a semiconductor layer (200) and a passivation layer (300) that are sequentially provided on the substrate (100);
subjecting the grid line precursor to a laser-induced contact treatment to form a metal grid line (400), and enabling the metal grid line (400) to extend through the passivation layer (300) to be in a direct contact with the semiconductor layer (200) to obtain a solar cell (2), wherein a plurality of enhanced conductive microstructures (500) are formed at a contact interface between the metal grid line (400) and the semiconductor layer (200), and the plurality of enhanced conductive microstructures (500) are aggregated in a specified area (101a) of the pyramidal textured structure (101), and the specified area (101a) is an area centered on a tip of the pyramidal textured structure (101) on the surface of the semiconductor layer (200) and within a distance from the tip of less than or equal to 1 µm,
wherein the enhanced conductive microstructures (500) each include a metal dendrite conductor;
placing an electrical connector (3) on the metal grid line (400), and pressing the electrical connector (3), such that the electrical connector (3) and the metal grid line (400) have a conductive contact area;
applying an adhesive to the conductive contact area to connect a plurality of solar cells (2) into a cell string, wherein pressing the electrical connector (3) and applying the adhesive are performed at a predetermined temperature less than or equal to 180°C, and the enhanced conductive microstructures (500) are aggregated in the specified area (101a) in the solar cells (2) of the cell string; and
stacking and laminating the cell string to obtain the photovoltaic module.

2. The method according to claim 1, wherein the metal grid line (400) comprises a busbar (401) and a finger (402) that are arranged perpendicular to each other, and a pad (403) located at at least one of the busbar (401), the finger (402), and an intersection of the busbar (401) and the finger (402), during pressing the electrical connector (3), a pressure is applied to an intersection of the electrical connector (3) and the pad (403), such that the electrical connector (3) and the pad (403) form the conductive contact area.

3. The method according to claim 2, wherein a line width of the finger (402) is in a range of 15 µm to 25 µm, and an area of the pad (403) is in a range of 0.04 mm×0.04 mm to 1.1 mm×1.1 mm.

4. The method according to claim 1, wherein the metal grid line (400) is a busbar-free grid line, and pressing the electrical connector (3) comprises: placing the electrical connector (3) on the metal grid line (400) in a direction perpendicular to an extending direction of the metal grid line (400), such that the electrical connector (3) and the metal grid line (400) form an intersection, and applying a pressure to a position of the electrical connector (3) corresponding to the intersection, such that the conductive contact area is formed in the position of the intersection.

5. The method according to claim 1, wherein during pressing the electrical connector (3), a pressure is applied to the electrical connector (3) for 10 s to 30 s.

6. The method according to claim 1, wherein during stacking and laminating the cell string, a temperature of lamination is in a range of 150°C to 200°C.

7. The method according to claim 1, wherein the electrical connector (3) is a tin-bismuth alloy solder ribbon with a soldering temperature of 150°C to 180°C.

8. The method according to claim 1, wherein the predetermined temperature is room temperature.

9. The method according to claim 1, wherein the adhesive is a conductive adhesive.

10. The method according to any one of claims 1 to 9, wherein the substrate (100) is a silicon substrate; and/or
the semiconductor layer (200) is a crystalline silicon semiconductor layer doped with a conductive element; and/or
the passivation layer (300) comprises one or more layers of an aluminum oxide layer, a silicon nitride layer, a silicon oxynitride layer, and a silicon oxide layer; and/or
the grid line paste is a silver paste, and an aluminum content in the grid line paste is less than or equal to 1wt%.

11. The method according to any one of claims 1 to 9, wherein subjecting the grid line precursor to the laser-induced contact treatment comprises: applying a reverse bias voltage of 9 V to 15 V when laser conditions are satisfied, and the laser conditions comprise: a single wavelength spectrum with a wavelength of 500 nm to 1200 nm, a current density of 1000 A/cm² to 1400 A/cm², and a scanning rate of 35 m/s to 55 m/s.

12. The method according to any one of claims 1 to 9, wherein the solar cell (2) comprises a back-contact solar cell or a passivated contact solar cell.

## Patentansprüche

1. Verfahren zur Herstellung eines fotovoltaischen Moduls, umfassend:
Drucken einer Rasterlinienpaste auf einer halbfertigen Solarzelle (1) und Sintern der Rasterlinienpaste, um einen Rasterlinienvorläufer zu bilden, wobei die halbfertige Solarzelle (1) ein Substrat (100), das einen pyramidenförmigen strukturierten Aufbau (101) auf einer Oberfläche davon aufweist, und eine Halbleiterschicht (200) und eine Passivierungsschicht (300) umfasst, die nacheinander auf dem Substrat (100) bereitgestellt sind;
Unterziehen des Rasterlinienvorläufers einer laserinduzierten Kontaktbehandlung, um eine Metallrasterlinie (400) zu bilden, und Ermöglichen, dass die Metallrasterlinie (400) sich durch die Passivierungsschicht (300) erstreckt, um in direktem Kontakt mit der Halbleiterschicht (200) zu sein, um die Solarzelle (2) zu erhalten, wobei eine Vielzahl von verstärkten leitfähigen Mikrostrukturen (500) an einer Kontaktgrenzfläche zwischen der Metallrasterlinie (400) und der Halbleiterschicht (200) gebildet wird, und die Vielzahl von verstärkten leitfähigen Mikrostrukturen (500) in einem vorgegebenen Bereich (101a) des pyramidenförmigen strukturierten Aufbaus (101) aggregiert wird und der vorgegebene Bereich (101a) sich in einem Bereich, zentriert an einer Spitze des pyramidenförmigen strukturierten Aufbaus (101), auf der Oberfläche der Halbleiterschicht (200) befindet und sich innerhalb eines Abstands kleiner oder gleich 1 µm von der Spitze befindet,
wobei die verstärkten leitfähigen Mikrostrukturen (500) jeweils einen Metalldendritenleiter einschließen;
Platzieren eines elektrischen Verbindungsstücks (3) auf der Metallrasterlinie (400) und Drücken des elektrischen Verbindungsstücks (3) derart, dass das elektrische Verbindungsstück (3) und die Metallrasterlinie (400) einen leitfähigen Kontaktbereich aufweisen;
Auftragen eines Klebstoffs auf den leitfähigen Kontaktbereich, um eine Vielzahl von Solarzellen (2) zu einem Zellenstrang zu verbinden, wobei das Drücken des elektrischen Verbindungsstücks (3) und das Auftragen des Klebstoffs bei einer vorbestimmten Temperatur kleiner oder gleich 180 °C durchgeführt werden, und die verstärkten leitfähigen Mikrostrukturen (500) im vorgegebenen Bereich (101a) in den Solarzellen (2) des Zellenstrangs aggregiert werden; und
Stapeln und Laminieren des Zellenstrangs, um das fotovoltaische Modul zu erhalten.

2. Verfahren nach Anspruch 1, wobei die Metallrasterlinie (400) eine Sammelschiene (401) und einen Finger (402), die senkrecht zueinander angeordnet sind, sowie ein Pad (403) umfasst, das sich an mindestens einem von der Sammelschiene (401), dem Finger (402) und einem Schnittpunkt der Sammelschiene (401) und des Fingers (402) befindet, während des Drückens des elektrischen Verbindungsstücks (3) ein Druck auf einen Schnittpunkt des elektrischen Verbindungsstücks (3) und des Pads (403) derart aufgebracht wird, dass das elektrische Verbindungsstück (3) und das Pad (403) den leitfähigen Kontaktbereich bilden.

3. Verfahren nach Anspruch 2, wobei eine Linienbreite des Fingers (402) in einem Bereich von 15 µm bis 25 µm liegt und eine Fläche des Pads (403) in einem Bereich von 0,04 mm × 0,04 mm bis 1,1 mm × 1,1 mm liegt.

4. Verfahren nach Anspruch 1, wobei die Metallrasterlinie (400) eine Rasterlinie ohne Sammelschiene ist und das Drücken des elektrischen Verbindungsstücks (3) Folgendes umfasst: Platzieren des elektrischen Verbindungsstücks (3) auf der Metallrasterlinie (400) in einer Richtung senkrecht zu einer Verlängerungsrichtung der Metallrasterlinie (400), sodass das elektrische Verbindungsstück (3) und die Metallrasterlinie (400) einen Schnittpunkt bilden, und Aufbringen eines Drucks an einer Stelle des elektrischen Verbindungsstücks (3), die dem Schnittpunkt entspricht, sodass der leitfähige Kontaktbereich an der Stelle des Schnittpunkts gebildet wird.

5. Verfahren nach Anspruch 1, wobei während des Drückens des elektrischen Verbindungsstücks (3) ein Druck auf das elektrische Verbindungsstück (3) für 10 s bis 30 s aufgebracht wird.

6. Verfahren nach Anspruch 1, wobei während des Stapelns und Laminierens des Zellenstrangs eine Laminierungstemperatur in einem Bereich von 150 °C bis 200 °C liegt.

7. Verfahren nach Anspruch 1, wobei das elektrische Verbindungsstück (3) ein Lötband aus einer Zinn-Wismut-Legierung mit einer Löttemperatur von 150 °C bis 180 °C ist.

8. Verfahren nach Anspruch 1, wobei die vorbestimmte Temperatur Raumtemperatur ist.

9. Verfahren nach Anspruch 1, wobei der Klebstoff ein leitfähiger Klebstoff ist.

10. Verfahren nach einem der Ansprüche 1 bis 9, wobei das Substrat (100) ein Siliziumsubstrat ist; und/oder
die Halbleiterschicht (200) eine kristalline Siliziumhalbleiterschicht ist, die mit einem leitfähigen Element dotiert ist; und/oder
die Passivierungsschicht (300) eine oder mehrere Schichten einer Aluminiumoxidschicht, einer Siliziumnitridschicht, einer Siliziumoxinitridschicht und einer Siliziumoxidschicht umfasst; und/oder
die Rasterlinienpaste eine Silberpaste ist und ein Aluminiumgehalt in der Rasterlinienpaste kleiner oder gleich 1 Gew.-% ist.

11. Verfahren nach einem der Ansprüche 1 bis 9, wobei das Unterziehen des Rasterlinienvorläufers der laserinduzierten Kontaktbehandlung Folgendes umfasst: Anlegen einer Sperrvorspannung von 9 V bis 15 V, wenn Laserbedingungen erfüllt werden, und wobei die Laserbedingungen Folgendes umfassen: ein einziges Wellenlängenspektrum mit einer Wellenlänge von 500 nm bis 1200 nm, eine Stromdichte von 1000 A/cm² bis 1400 A/cm² und eine Scangeschwindigkeit von 35 m/s bis 55 m/s.

12. Verfahren nach einem der Ansprüche 1 bis 9, wobei die Solarzelle (2) eine Solarzelle mit rückwärtigem Kontakt oder eine Solarzelle mit passiviertem Kontakt umfasst.

## Revendications

1. Procédé de préparation d'un module photovoltaïque, comprenant :
l'impression d'une pâte de ligne de grille sur une cellule solaire semi-finie (1), et le frittage de la pâte de ligne de grille pour former un précurseur de ligne de grille, dans lequel la cellule solaire semi-finie (1) comprend un substrat (100) présentant une structure texturée pyramidale (101) sur une surface de celui-ci, et une couche semi-conductrice (200) et une couche de passivation (300) qui sont séquentiellement disposées sur le substrat (100) ;
la soumission du précurseur de ligne de grille à un traitement de contact induit par laser pour former une ligne de grille métallique (400), et le fait de permettre à la ligne de grille métallique (400) de s'étendre à travers la couche de passivation (300) pour être en contact direct avec la couche semi-conductrice (200) afin d'obtenir une cellule solaire (2), dans lequel une pluralité de microstructures conductrices améliorées (500) sont formées à une interface de contact entre la ligne de grille métallique (400) et la couche semi-conductrice (200), et la pluralité de microstructures conductrices améliorées (500) sont agrégées dans une zone spécifiée (101a) de la structure texturée pyramidale (101), et la zone spécifiée (101a) est une zone centrée sur une extrémité de la structure texturée pyramidale (101) sur la surface de la couche semi-conductrice (200) et à une distance de l'extrémité inférieure ou égale à 1 µm,
dans lequel les microstructures conductrices améliorées (500) incluent chacune un conducteur de dendrite métallique ;
la mise en place d'un connecteur électrique (3) sur la ligne de grille métallique (400), et la compression du connecteur électrique (3), de sorte que le connecteur électrique (3) et la ligne de grille métallique (400) présentent une zone de contact conductrice ;
l'application d'un adhésif sur la zone de contact conductrice pour connecter une pluralité de cellules solaires (2) dans une chaîne de cellules, dans lequel la compression du connecteur électrique (3) et l'application de l'adhésif sont réalisées à une température prédéterminée inférieure ou égale à 180 °C, et les microstructures conductrices améliorées (500) sont agrégées dans la zone spécifiée (101a) dans les cellules solaires (2) de la chaîne de cellules ; et
l'empilement et la stratification de la chaîne de cellules pour obtenir le module photovoltaïque.

2. Procédé selon la revendication 1, dans lequel la ligne de grille métallique (400) comprend une barre omnibus (401) et un doigt (402) qui sont agencés perpendiculairement l'un à l'autre, et une pastille (403) se situant au moins au niveau de l'un(e) de la barre omnibus (401), du doigt (402) et d'une intersection entre la barre omnibus (401) et le doigt (402), lors de la compression du connecteur électrique (3), une pression est appliquée à l'intersection entre le connecteur électrique (3) et la pastille (403), de sorte que le connecteur électrique (3) et la pastille (403) forment la zone de contact conductrice.

3. Procédé selon la revendication 2, dans lequel une largeur de ligne du doigt (402) est dans une plage de 15 µm à 25 µm, et une zone de la pastille (403) est dans une plage de 0,04 mm × 0,04 mm à 1,1 mm × 1,1 mm.

4. Procédé selon la revendication 1, dans lequel la ligne de grille métallique (400) est une ligne de grille sans barre omnibus, et la compression du connecteur électrique (3) comprend : la mise en place du connecteur électrique (3) sur la ligne de grille métallique (400) dans une direction perpendiculaire à une direction d'extension de la ligne de grille métallique (400), de sorte que le connecteur électrique (3) et la ligne de grille métallique (400) forment une intersection, et l'application d'une pression sur une position du connecteur électrique (3) correspondant à l'intersection, de sorte que la zone de contact conductrice soit formée dans la position de l'intersection.

5. Procédé selon la revendication 1, dans lequel, pendant la compression du connecteur électrique (3), une pression est appliquée au connecteur électrique (3) pendant 10 s à 30 s.

6. Procédé selon la revendication 1, dans lequel, pendant l'empilement et la stratification de la chaîne de cellules, une température de stratification est dans une plage de 150 °C à 200 °C.

7. Procédé selon la revendication 1, dans lequel le connecteur électrique (3) est un ruban de soudure en alliage d'étain-bismuth avec une température de soudage de 150 °C à 180 °C.

8. Procédé selon la revendication 1, dans lequel la température prédéterminée est une température ambiante.

9. Procédé selon la revendication 1, dans lequel l'adhésif est un adhésif conducteur.

10. Procédé selon l'une quelconque des revendications 1 à 9, dans lequel le substrat (100) est un substrat de silicium ; et/ou
la couche semi-conductrice (200) est une couche semi-conductrice en silicium cristallin dopée avec un élément conducteur ; et/ou
la couche de passivation (300) comprend une ou plusieurs couches parmi une couche d'oxyde d'aluminium, une couche de nitrure de silicium, une couche d'oxynitrure de silicium et une couche d'oxyde de silicium ; et/ou
la pâte de ligne de grille est une pâte d'argent, et une teneur en aluminium dans la pâte de ligne de grille est inférieure ou égale à 1 % en poids.

11. Procédé selon l'une quelconque des revendications 1 à 9, dans lequel la soumission du précurseur de ligne de grille au traitement de contact induit par laser comprend : l'application d'une tension de polarisation inverse de 9 V à 15 V lorsque des conditions laser sont satisfaites, et les conditions laser comprennent : un spectre à longueur d'onde unique avec une longueur d'onde de 500 nm à 1 200 nm, une densité de courant de 1 000 A/cm² à 1 400 A/cm² et une vitesse de balayage de 35 m/s à 55 m/s.

12. Procédé selon l'une quelconque des revendications 1 à 9, dans lequel la cellule solaire (2) comprend une cellule solaire à contact arrière ou une cellule solaire à contact passivé.
